# EUROPÄISCHE PATENTSCHRIFT

(11) **EP 1 738 183 B1**
(45) Veröffentlichungstag und Bekanntmachung des Hinweises auf die Patenterteilung: **27.07.2011**
(21) Anmeldenummer: 05735462.3
(22) Anmeldetag: 19.04.2005
(51) Int. Cl.: G01R 1/04

(54) **UMVERDRAHTUNGSSUBSTRATSTREIFEN MIT MEHREREN HALBLEITERBAUTEILPOSITIONEN**
REWIRING SUBSTRATE STRIP WITH SEVERAL SEMICONDUCTOR COMPONENT POSITIONS
BANDE DE SUBSTRAT DE RECABLAGE A PLUSIEURS EMPLACEMENTS POUR COMPOSANTS A SEMI-CONDUCTEURS

(30) Priorität: 22.04.2004 DE 102004020187
(43) Veröffentlichungstag der Anmeldung: 03.01.2007
(73) Patentinhaber: Infineon Technologies AG, 85579 Neubiberg (DE)
(72) Erfinder: OSSIMITZ, Peter, 81377 München (DE)
(74) Vertreter: Schäfer, Horst
(86) Internationale Anmeldenummer: PCT/DE2005/000714
(87) Internationale Veröffentlichungsnummer: WO 2005/103729

(56) Entgegenhaltungen:
- US-A- 4 467 400
- US-A1- 2003 237 061
- US-B1- 6 380 729

## Beschreibung

Die Erfindung betrifft einen Umverdrahtungssubstratstreifen mit mehreren Halbleiterbauteilpositionen und Halbleiterbauteile des Umverdrahtungssubstratstreifens, die in Zeilen und Spalten auf dem Umverdrahtungssubstratstreifen angeordnet sind, sowie ein Verfahren zur Herstellung derselben.

Für Halbleiterbauteile wird zunehmend eine Minimierung der produzierten Produktgehäusegröße angestrebt. Dazu wird die Anzahl der Außenkontakte auf ein Minimum reduziert und angestrebt, möglichst viele Außenkontakte eines Halbleiterbauteils, die für Testoptimierungszwecke und Analysenzwecke bisher vorgesehen sind, zu vermeiden. Mit einer derartigen Reduzierung der Außenkontakte ist der Nachteil verbunden, dass Außenkontakte zu internen Test- und Analysezwecken nicht mehr extern am Gehäuse bereitgestellt werden. Daraus ergeben sich zwar kleinere Produktgehäuse, jedoch ergeben sich auch gleichzeitig, nachteilig, signifikante Einschränkungen bei der Analyse und der Testbarkeit derartiger Halbleiterbauteile und ihrer Zwischenproduktstufen.

Die damit verbundenen Risiken in Bezug auf die Ausbeute funktionsfähiger Halbleiterbauteile aus einem Umverdrahtungssubstratstreifen können nicht durch weitere verbesserte Fertigungsverfahren komprimiert werden. Somit wird in der Technik zwischen einem Produktgehäuse, das die minimal erforderliche Anzahl von Außenkontakten aufweist und einem sogenannten Debug-Gehäuse unterschieden, wobei das Debug-Gehäuse zusätzliche entfernbare Prüfkontakte aufweist, die nach einem Test auf Funktionsfähigkeit von dem eigentlichen Produktionsgehäuse getrennt werden.

Werden zusätzlich zu den Außenkontakten des Produktgehäuses Prüfflächen auf einem Debug-Bauteil, das größer ist, als das Produktbauteil, zur Verfügung gestellt, so ergeben sich vielfältige Möglichkeiten zum Testen des Bauteils durch Hinzufügung von Prüfkontaktflächen in Randbereichen des Debug-Bauteils. Jedoch entsteht ein erhöhter Flächenbedarf mit zunehmender Anzahl von Prüfflächen zwischen den Halbleiterbauteilen einer Bauteilgruppe eines Umverdrahtungssubstratstreifens.

Das Dokument US 6,380,729 B1 offenbart einen Umverdrahtungssubstratstreifen mit mehreren Halbleiterbauteilpositionen für Halbleiterbauteile. Ferner sind Prüfkontaktflächen vorgesehen, die derart angeordnet sind, eine aleatorische Ausrichtung der Halbleiterbauteile während eines Prüfvorganges zu kompensieren.

Das Dokument US 2003/237061 A1 offenbart einen Halbleiterwafer, welcher in mehrere Halbleiterchips vereinzelt wird. Die Halbleiterchips werden anschließend zum Prüfen auf einem Träger angeordnet, wobei alle Halbleiterchips auf dem Träger in ein und dieselbe Richtung orientiert angeordnet sind.

Das Dokument US 4,467,400 offenbart mehrere, auf einem Substrat angeordnete Halbleiterchips, welche mit Prüfkontakten versehen sind.

Aufgabe der Erfindung ist es, einen Umverdrahtungssubstratstreifen mit mehreren Halbleiterbauteilpositionen zu schaffen, mit dem die obigen Probleme überwunden werden können. Dabei soll trotz reduzierter Anzahl von Außenkontakten und reduzierter Gehäusegröße eine Analyse und Testbarkeit interner Signale für die Prozessoptimierung, für die Korrelation zu anderen Gehäuseformen, sowie für die Charakterisierung der Halbleiterbauteile erhalten bleiben. Ferner soll eine optimierte Anordnung und Ausrichtung von Halbleiterbauteilen in den Halbleiterbauteilpositionen geschaffen werden, die verkleinerte Produktgehäuse und eine optimierte Größe der Debug-Bauteile ermöglichen. Schließlich sollen Tests ohne Beschädigung oder Verformung von Außenkontakten möglich werden. Darüber hinaus ist es eine Aufgabe der Erfindung eine einfache und kostengünstige Lösung für mechanische und elektrische Kontaktierungen von Halbleiterbauteilen oder von Halbleitermodulen hochintegrierter Schaltung für einen "burn-in"-Test anzugeben.

Gelöst wird diese Aufgabe mit dem Gegenstand der unabhängigen Ansprüche. Vorteilhafte Weiterbildungen der Erfindung ergeben sich aus den abhängigen Ansprüchen.

Erfindungsgemäß wird ein Umverdrahtungssubstratstreifen mit mehreren Halbleiterbauteilpositionen für Halbleiterbauteile geschaffen und ein Verfahren zu dessen Herstellung angegeben. Die Halbleiterbauteile sind in mehreren Bauteilzeilen und Bauteilspalten, unterteilt durch Sägespuren, auf dem Umverdrahtungssubstratstreifen angeordnet. Dazu sind mehrere Halbleiterbauteilpositionen zu einer Bauteilgruppe zusammengefasst. Die Halbleiterbauteilgruppe umfasst mehrere Halbleiterchips der Halbleiterbauteile auf einer Oberseite des Umverdrahtungssubstratstreifens. Innerhalb einer Bauteilgruppe sind zwischen den Bauteilzeilen und Bauteilspalten Sägestreifen vorgesehen, die von Sägespuren begrenzt sind und die Prüfkontaktflächen aufweisen.

Die Halbleiterbauteilpositionen einschließlich ihrer Prüfkontaktflächen sind derart zueinander ausgerichtet, dass sich ein Parkettierungsmuster gemäß einem Parallel-Stab Parkettmuster ergibt. Die Anordnungen von Außenkontakten und Prüfkontaktflächen der Halbleiterbauteile sind entsprechend dem Parkettierungsmuster derart zueinander angeordnet und ausgerichtet, dass vier nächste Nachbarn eines Halbleiterbauteils eine Anordnung der Außenkontakte aufweisen, die um einheitlich 90° oder um einheitlich 270° gegenüber der Anordnung des einzelnen Halbleiterbauteils gedreht ausgerichtet ist.

Der Umverdrahtungssubstratstreifen hat den Vorteil, dass die Fläche, die für eine Bauteilgruppe vorzusehen ist, dahingehend optimiert ist, dass möglichst viele Prüfkontaktflächen in entsprechenden Sägestreifenabschnitten für jedes der Bauteilpositionen zur Verfügung gestellt werden kann. Ferner wird durch die Ausrichtung der vier nächsten Nachbarn eines Halbleiterchips um einheitlich 90° oder um einheitlich 270° gedreht zu dem Halbleiterchip erreicht, dass die Verbindungsleitungen zwischen Außenkontakten und Prüfflächen in ihrer Länge und Dichte optimiert werden können.

Derartige Verbindungsleitungen zwischen Außenkontakten des Produktgehäuses und Prüfkontaktflächen des Debug-Gehäuses können in vorteilhafter Weise, sowohl auf der Oberseite des Umverdrahtungssubstratstreifens, als auch auf der Rückseite des Umverdrahtungssubstratstreifens in Form von Umverdrahtungsleitungen realisiert werden. Die Rückseite wird vorteilhafter Weise dann gewählt, wenn die Prüfung auf der Seite der Außenkontakte erfolgen soll, und die Oberseite wird dann für die Umverdrahtungsleitungen und für die Prüfkontaktflächen eingesetzt, wenn die Prüfung auf der den Außenkontakten gegenüber liegenden Oberseite des Umverdrahtungssubstratstreifens, auf der sich auch die Halbleiterchips befinden, stattfinden soll. Die einheitlich gedrehte Ausrichtung von vier nächsten Nachbarn zu einem Halbleiterchip hat darüber hinaus den Vorteil, dass beim Bestücken der Oberseite des Umverdrahtungssubstratstreifens mit Halbleiterchips der Bestückungsautomat lediglich zwei um einen festen Winkel zueinander gedrehte Ausrichtungen der Halbleiterchips vorzunehmen hat oder nur zwei vorbestimmte Ausrichtungen der Halbleiterchips durch den Bestückungsautomaten von einem entsprechend vorbereiteten Halbleiterwafer oder einem entsprechend vorbereiteten Zwischenträger oder von einem entsprechend vorbereiteten Transportband aufzunehmen sind.

In einer weiteren Ausführungsform der Erfindung weisen Bauteilzeilen und Bauteilspalten einer Bauteilgruppe erste und zweite Halbleiterchips auf. Dabei unterscheiden sich die ersten und zweiten Halbleiterchips in ihren Ausrichtungen. Die ersten Halbleiterchips weisen eine erste Ausrichtung A auf, während die zweiten Halbleiterchips einheitlich eine Ausrichtung B aufweisen, die entweder um 90° oder einheitlich um 270° gegenüber der ersten Ausrichtung A gedreht ist. Die ersten und zweiten Halbleiterchips sind dann in den Bauteilzeilen und Bauteilspalten alternierend angeordnet.

Somit kann in vorteilhafter Weise, z.B. jede ungerade Halbleiterbauteilposition in den Bauteilzeilen und Bauteilspalten einer Bauteilgruppe, die Ausrichtung A aufweisen. Entsprechend weisen dann die geraden Halbleiterbauteilpositionen in den Bauteilzeilen und den Bauteilspalten einer Bauteilgruppe die Ausrichtung B auf. Damit ist der Vorteil verbunden, dass die Anordnung der Außenkontakte auf der Rückseite des Halbleiterchips genauso ausgerichtet ist, wie die Halbleiterchips auf der Oberseite des Umverdrahtungssubstratstreifens, was die Umverdrahtungsstruktur innerhalb des Umverdrahtungssubstratstreifens und/oder auf seiner Oberseite und seiner Rückseite vorteilhaft vereinfacht.

In einer bevorzugten Ausführungsform der Erfindung sind auf einer Rückseite des Umverdrahtungssubstratstreifens, die der Oberseite gegenüberliegt, in den Halbleiterpositionen Außenkontakt aufweisende Außenkontaktflecken angeordnet. Diese Außenkontaktflecken gehören zu einer Umverdrahtungsstruktur, welche Umverdrahtungsleitungen aufweist. Diese Umverdrahtungsleitungen der Umverdrahtungsstruktur verbinden die Außenkontaktflecken mit den Prüfkontaktflächen auf den Sägestreifen des Umverdrahtungssubstratstreifens.

Diese Ausführungsform der Erfindung hat den Vorteil, dass der Umverdrahtungssubstratstreifen relativ preiswert hergestellt werden kann, zumal er lediglich auf seiner Rückseite, auf der sowieso die Außenkontaktflecken vorzusehen sind, eine Umverdrahtungsstruktur mit Umverdrahtungsleitung zu den Prüfkontaktflächen benötigt. Auf der Oberseite des Umverdrahtungssubstratstreifens sind entsprechend nur solche metallischen Strukturen notwendig, die ein Verbinden des Umverdrahtungssubstratstreifens mit den Halbleiterchips in jeder der Halbleiterbauteilpositionen ermöglichen und es sind Durchkontakte zu den Außenkontaktflecken auf der Rückseite des Umverdrahtungssubstratstreifens erforderlich. Somit sind sowohl die Rückseite als auch die Oberseite des Umverdrahtungssubstratstreifens mit herkömmlichen Technologien, wie sie auch aus der Leiterplattenherstellung bekannt sind, strukturierbar, was die Kosten für den Umverdrahtungssubstratstreifen vermindert.

In einer weiteren bevorzugten Ausführungsform der Erfindung sind den jeweiligen Halbleiterbauteilpositionen Sägestreifenabschnitte zugeordnet, die Prüfkontaktflächen tragen und auf zwei gegenüber liegenden Randseiten des Produktgehäuses angeordnet sind. Damit ist der Vorteil verbunden, dass auch für ein Produktgehäuse mit quadratischem Grundriss ein rechteckiges Debug-Gehäuse entsteht, welches die Grundlage eines Parallel- Stab Parkettmusters bildet. Bei diesem Muster entstehen Kreuzungsflächen, die durch das Kreuzen von horizontalen und vertikalen Sägestreifen entlang der Bauteilzeilen und der Bauteilspalten gebildet sind.

Diese Kreuzungsflächen können in einer weiteren Ausführungsform der Erfindung ebenfalls zum Anordnen von Prüfkontaktflächen für eine optimale Nutzung der Fläche einer Bauteilgruppe eingesetzt werden. Dazu wird ein Viertel dieser Prüfkontaktflächen auf einer Kreuzungsfläche jeweils einer der vier angrenzenden Halbleiterbauteilpositionen zugeordnet. Somit erhöht sich in vorteilhafter Weise die mögliche Anzahl von Prüfkontaktflächen pro Halbleiterbauteilposition, zumal vier Kreuzungsflächen gemäß dem Parkettierungsmuster zu einer Halbleiterposition benachbart sind, womit die für Prüfkontaktflächen nutzbare Fläche der Bauteilpositionen um eine gesamte Kreuzungsfläche pro Bauteilposition erhöht werden kann.

Weiterhin ist es vorgesehen, dass mehrere Bauteilgruppen auf dem Umverdrahtungssubstratstreifen hintereinander und/oder nebeneinander aufgereiht sind und vorzugsweise eine oder mehrere Kunststoffabdeckungen aufweisen. Derartige Kunststoffabdeckungen sind insbesondere erforderlich, wenn die elektrischen Verbindungen zwischen Halbleiterchip und Umverdrahtungssubstratstreifen mittels Bondtechnik und damit mittels empfindlicher Bonddrähte erreicht wird. Diese Kunststoffabdeckungen auf den Bauteilgruppen sichern und schützen derartige Bonddrähte der Bondverbindungen zwischen Halbleiterchip und Umverdrahtungssubstratstreifen.

Eine andere mögliche Verbindung zwischen Halbleiterchip und Umverdrahtungssubstratstreifen ist durch die so genannte Flipchip-Technik möglich. Dazu sind auf der aktiven Oberseite des Halbleiterchips Kontaktflächen, die sonst für Bondverbindungen zur Verfügung stehen mit Flipchip-Kontakten versehen, welche unmittelbar auf entsprechende Kontaktanschlussflächen auf dem Umverdrahtungssubstratstreifen aufgelötet werden können. Da bei dieser Ausführungsform der Erfindung eine relativ stabile Lötverbindung über die Flipchip-Kontakte zwischen dem Halbleiterchip und dem Umverdrahtungssubstratstreifen mit entsprechenden Kontaktanschlussflächen erreicht wird, sind bei dieser Ausführungsform der Erfindung auch Gehäuse ohne schützende Kunststoffabdeckung möglich.

Bei einer weiteren Ausführungsform der Erfindung ist es vorgesehen, dass der Umverdrahtungssubstratstreifen auf seiner Rückseite, außerhalb des Bereichs einer Bauteilgruppe, Bereiche mit freiliegenden Testkontaktflächen aufweist. Diese Testkontaktflächen sind über Umverdrahtungsleitungen mit den Prüfkontaktflächen in den Sägestreifen und/oder den Außenkontaktflecken der Halbleiterbauteile und/oder mit Kontaktflächen auf der aktiven Seite der Halbleiterchips elektrisch verbunden. Diese Ausführungsform der Erfindung hat den Vorteil, dass über diese zusätzlichen Testkontaktflächen außerhalb der Bauteilgruppen bisher nicht vorgesehene Messungen und Prüfungen zusätzlich auf dem Umverdrahtungssubstratstreifen durchgeführt werden können. Während die Fläche einer Bauteilgruppe optimiert und minimiert ist, verfügt der Umverdrahtungssubstratstreifen über genügend große Bereiche außerhalb einer Baugruppe, um derartige zusätzliche Testkontaktflächen zur Verfügung zu stellen. Damit können die Analysen und Tests der einzelnen integrierten Schaltungen vorteilhaft erweitert werden.

Eine weitere Verbesserung der Prüfmöglichkeiten für den Umverdrahtungssubstratstreifen besteht darin, dass für eine Bauteilgruppe eine Testkontaktleiste im Randbereich des Umverdrahtungssubstratstreifens für einen Temperaturzyklentest bzw. einen "burn-in"-Test vorgesehen ist. Für diesen so genannten "burn-in"-Test werden charakteristische Halbleiterbauteilelemente auf dem Halbleiterchip über ein Bündel entsprechender Umverdrahtungsleitungen mit der Steckkontaktleiste verbunden, sodass nicht einzelne Bauelemente für den "burn-in"-Test vorzubereiten sind, sondern es können noch auf dem Umverdrahtungssubstratstreifen diese Temperaturzyklentests für ganze Baugruppen durchgeführt werden. Eine derartige Steckkontaktleiste kann, sowohl auf der Rückseite, als auch auf der Oberseite des Umverdrahtungssubstratstreifens angeordnet sein. Dabei können die einzelnen Steckkontaktflächen einer Steckkontaktleiste mit den Prüfkontaktflächen und/oder den Außenkontaktflecken und/oder den Kontaktflächen einer aktiven Oberseite eines Halbleiterchips elektrisch in Verbindung stehen. Zusätzlich können weitere Umverdrahtungsleitungen mit der Steckkontaktleiste verbunden sein, um darüber hinausgehende Funktionstests der einzelnen Halbleiterbauteile einer Halbleiterbauteilgruppe über die Steckkontaktleiste vorzunehmen.

Statt eine Kontaktierung über die Steckkontaktleiste zu ermöglichen, können auch die Prüfkontaktflächen entweder unmittelbar mit entsprechenden Prüfsonden in Verbindung gebracht werden oder es werden Prüfkontakte auf die Prüfkontaktflächen aufgebracht. Derartig aufgebrachte Prüfkontakte haben den Vorteil, dass die Messsonden in Form von Messspitzen nicht auf den Außenkontakten oder auf den Prüfkontaktflächen eines Produktgehäuses bzw. eines Debug-Gehäuses aufgebracht werden müssen. Somit werden die Außenkontakte eines Produktgehäuses bzw. die Prüfkontaktflächen eines Debug-Gehäuses, weder von den Messspitzen kontaminiert noch umgekehrt die Messspitzen von den Außenkontakten bzw. den Prüfkontaktflächen kontaminiert.

Um die Kontaminationsgefahr der Messspitzen durch Prüfkontaktflächen oder Prüfkontakte zu weiterhin vermindern, können Prüfkontaktflächen bzw. Prüfkontakte in einer weiteren Ausführungsform der Erfindung mit einer Goldbeschichtung belegt sein. Eine derartige Goldbeschichtung der Prüfkontaktflächen oder der Prüfkontakte verbessert außerdem den Kontaktübergangswiderstand, zumal Gold nicht wie Aluminium oder Kupfer an der Luft oxidiert oder wie Silber an Luft sulfidiert wird.

Eine weitere Ausführungsform der Erfindung ermöglicht, insbesondere durch das Vorsehen von Debug-Gehäusen mit einer entsprechend hohen Anzahl von Prüfkontaktflächen, das Prüfen von Umverdrahtungssubstratstreifen mit einem Stapel aus einem Logikchip und einem Speicherchip in den Halbleiterbauteilpositionen. Dabei können über die Prüfkontaktflächen und/oder die freiliegenden Testkontaktflächen und/oder über die Steckkontaktleisten, sowohl die Speicherfunktionen des Speicherchips, als auch die Logikfunktionen des Logikchips noch vor dem Verpacken und Weiterverarbeiten des Umverdrahtungssubstratstreifens zu einzelnen Halbleiterbauteilen geprüft werden.

Halbleiterbauteile, die auf der Basis derartiger Umverdrahtungssubstratstreifen hergestellt wurden, können leicht identifiziert werden, zumal sie auf gegenüberliegenden Randseiten ihres Gehäuses durchgetrennte Umverdrahtungsleitungen, die zu den Prüfkontaktflächen auf den Sägestreifen des Umverdrahtungssubstrats führen, nach dem Vereinzeln zu Halbleiterbauteilen aufweisen. Ein derartiges Halbleiterbauteil hat den Vorzug, dass es noch vor einem Verkapseln oder einem Abdecken durch eine Kunststoffmasse intensiv geprüft werden kann, sodass entweder die Möglichkeit besteht, defekte Halbleiterchips vor dem Verpacken zu identifizieren und zu entfernen, oder die defekten Halbleiterchips beizubehalten, jedoch derart zu markieren, dass sie nach dem Auftrennen zu einzelnen Halbleiterbauteilen noch erkennbar sind und aussortiert werden können.

Ein Verfahren zur Herstellung eines Umverdrahtungssubstratstreifens mit mehreren Bauteilgruppen, die in x-Richtung in Bauteilzeilen und in y-Richtung in Bauteilspalten angeordnete Halbleiterbauteilpositionen mit Halbleiterchips aufweisen, weist nachfolgende Verfahrensschritte auf.

Zunächst wird ein Substratstreifen bereitgestellt, der mindestens auf seiner Rückseite metallbeschichtet ist. Diese Metallbeschichtung wird zu einer Umverdrahtungsstruktur strukturiert, die Außenkontaktflecken in den Halbleiterbauteilpositionen und Prüfkontaktflächen im Bereich von Sägestreifen zwischen den Halbleiterbauteilpositionen aufweist. Nachdem eine derartige Umverdrahtungsstruktur hergestellt ist, werden auf die Oberseite des Umverdrahtungssubstratstreifens Halbleiterchips in den Halbleiterbauteilpositionen nach einem vorbestimmten Plan aufgebracht. Zunächst wird jede ungerade Halbleiterbauteilposition in den Bauteilzeilen und den Bauteilspalten mit einem ersten Halbleiterchip in einer ersten Ausrichtung A bestückt.

Anschließend werden die verbliebenen geraden Halbleiterpositionen in den Bauteilspalten und den Bauteilzeilen mit einem zweiten Halbleiterchip bestückt, wobei die zweiten Halbleiterchips gegenüber der ersten Ausrichtung A einheitlich eine um 90° oder einheitlich eine um 270° verdrehte Ausrichtung B aufweisen. Dabei können, sowohl die ersten, als auch die zweiten Halbleiterchips völlig identische integrierte Schaltungen aufweisen. Die erste Ausrichtung A und die zweite Ausrichtung B bewirken, dass ein Stab Parkettmuster nach vorgegebenem Plan in x- und y-Richtung gebildet wird.

Nachfolgend werden Verbindungen zwischen den Halbleiterchips und der Umverdrahtungsstruktur hergestellt. Danach werden Außenkontakte in den Halbleiterbauteilpositionen auf die Außenkontaktflecken der Umverdrahtungsstruktur auf der Rückseite des Umverdrahtungssubstratstreifens aufgebracht. Anschließend erfolgen Funktionstests der Halbleiterchips der Halbleiterbauteile unter Kontaktieren der Prüfkontaktflächen und/oder von Testkontaktflächen und/oder von Steckkontaktflächen einer Steckkontaktleiste. Abschließend werden die defekten Halbleiterbauteile auf dem Umverdrahtungssubstratstreifen markiert.

Dieses Verfahren hat den Vorteil, dass aufgrund der zusätzlichen Prüfkontaktflächen auf den Sägestreifen in den Bauteilgruppen und den zusätzlichen Steckkontaktflächen auf Randseiten des Umverdrahtungssubstratstreifens eine vollständige und verbesserte Durchführung von Funktionstests der Halbleiterchips möglich ist, ohne jedoch die Außenkontakte auf dem Umverdrahtungssubstratstreifen kontaktieren zu müssen. Darüber hinaus hat dieses Verfahren den Vorteil, dass auch die interne Signalverarbeitung in den zu Baugruppen angeordneten Halbleiterchips geprüft werden kann, ohne dass zusätzliche Außenkontakte für das Produktgehäuse erforderlich werden.

Mit diesem Verfahren lassen sich folglich Bauteile herstellen, die verkleinerte Gehäuse aufweisen, bei gleichzeitiger Reduzierung der Anzahl der Außenkontakte und die dennoch einem vollständigen und verbesserten Funktionstest auch für die interne Signalverarbeitung unterzogen werden können. Durch das Anordnen der Steckkontaktleiste lässt sich darüber hinaus ein "burn-in"-Testzyklusverfahren direkt mithilfe des Umverdrahtungssubstratstreifens durchführen. Somit können die Halbleiterbauteile noch vor dem Auftrennen der Bauteilgruppen in einzelne Halbleiterbauteile unter extremer Temperaturzyklusbelastung getestet werden.

Diese Vorteile, nämlich die Schonung der Außenkontakte des Produktgehäuses, die erweiterten Test- und Analysemöglichkeit von inneren Signalverläufen sämtlicher Halbleiterchips und die Prüfung jeder Bauteilgruppe mit mehreren Halbleiterbauteilen innerhalb beispielsweise einer Kunststoffabdeckung unter extremen Temperaturschwankungen, werden bei diesem erfindungsgemäßen Verfahren mithilfe des Parkettierungsmusters des erfindungsgemäßen Umverdrahtungssubstratstreifens möglich. Die Sägestreifen mit ihren Prüfflächen werden beim Vereinzeln der Halbleiterbauteile herausgesägt, sodass das Produktgehäuse klein bleibt, da die Prüfkontakte von dem sogenannten Debug-Gehäuse gemeinsam entfernt werden.

Eine weitere Verfahrensvariante sieht vor, dass die Halbleiterchips gleichförmig und einheitlich ausgerichtet auf die Oberseite des Umverdrahtungssubstratstreifens aufgebracht werden. Für die Umverdrahtungsstruktur wird jedoch auf dem Umverdrahtungssubstratstreifen vorgesehen, dass in den Halbleiterbauteilpositionen des Umverdrahtungssubstratstreifens eine Ausrichtung der Anordnung von Außenkontakten gegenüber der Ausrichtung der Halbleiterchips in den Bauteilzeilen und den Bauteilspalten für ungerade Halbleiterbauteilpositionen einheitlich eine um 0° und/oder 180° und für gerade Halbleiterbauteilpositionen in den Bauteilzeilen und den Bauteilspalten eine gegenüber der Ausrichtung der Halbleiterchips einheitlich um 90° und/oder einheitlich um 270° verdrehte Ausrichtung vorgesehen wird.

Somit wird die unterschiedliche, vorgegebene Rotation in den geraden und den ungeraden Halbleiterbauteilpositionen mittels eines vorgegebenen Umverdrahtungsplanes für einen mehrlagigen Umverdrahtungssubstratstreifen durchgeführt und ein Verdrehen von Halbleiterchips vermieden. Das bedeutet, dass der mehrlagige Umverdrahtungssubstratstreifen zwar komplexer aufgebaut ist, zumal er die geforderte unterschiedliche Rotation von Anordnungen von Außenkontakten über entsprechend strukturierte Umverdrahtungsleitungen und Durchkontakte realisiert, besteht der Vorteil darin, dass die Bestückung des Umverdrahtungssubstratstreifens in den Bauteilgruppen vereinfacht wird, zumal die Halbleiterchips einer Bauteilgruppe einheitlich ausgerichtet bleiben können.

Bei einer weiteren Durchführungsvariante des Verfahrens stehen zum Aufbringen von unterschiedlich ausgerichteten und angeordneten Halbleiterchips auf einem Umverdrahtungssubstratstreifen ein in Halbleiterchips getrennter Wafer zur Verfügung. Dieser Wafer weist in x- und y-Anordnung, sowie in Rotationsausrichtung vorbereitend ausgerichtete und angeordnete Halbleiterchips auf. Diese werden von einem Bestückungsautomaten in der vorgegebenen Anordnung und Ausrichtung des Wafers auf die Oberseite des Umverdrahtungssubstratstreifens aufgebracht.

Dieses Verfahren mit einem bereits für das Aufbringen auf die Oberseite eines Umverdrahtungssubstratstreifens vorbereiteten Halbleiterwafers hat den Vorteil, dass mit einem Standardbestückungsautomaten ohne jede zusätzliche Rotation die Bestückung des Umverdrahtungssubstratstreifens mit Halbleiterchips, die unterschiedlich ausgerichtet sind, in den Bauteilpositionen einer Bauteilgruppe durchgeführt werden kann. Der gleiche Vorteil ergibt sich, wenn in einer weiteren Durchführungsvariante des Verfahrens eine Folie mit flächig angeordneten Halbleiterchips oder ein Transportgurt mit linear angeordneten Halbleiterchips zur Verfügung steht, die in x-, y-Anordnung und/oder in Rotationsausrichtung vorbereitend ausgerichtete und angeordnete Halbleiterchips aufweisen. Auch von einer derartigen Folie bzw. einem derartigen Transportgurt können die Halbleiterchips mit einem Standardbestückungsautomaten ohne jede zusätzliche Rotation in vorgegebener Anordnung und Ausrichtung auf die Oberseite des Umverdrahtungssubstratstreifens aufgebracht werden.

Eine weitere Verfahrensvariante sieht vor, dass zum Aufbringen von unterschiedlich ausgerichteten und angeordneten Halbleiterchips auf dem Umverdrahtungssubstratstreifen ein in x-und in y-Anordnung, sowie Rotationsausrichtung programmierbarer Bestückungsautomat eingesetzt wird. Dieser Bestückungsautomat nimmt angeordnete und gleichförmig ausgerichtete Halbleiterchips von einem in Halbleiterchips getrennten Wafer oder von einer einheitlich mit Halbleiterchips bestückten Folie oder aus einem Transportgurt auf, und verbringt sie nach einem vorgesehenen Anordnungs- und Ausrichtungsplan beim Bestücken des Umverdrahtungssubstratstreifens programmgemäß auf diesen auf. Bei dieser Verfahrensvariante ist zwar ein höherer Aufwand für die Auslegung und Konstruktion des programmierbaren Bestückungsautomaten erforderlich, jedoch können die Halbleiterchips in standardisierter Weise auf einem Wafer oder auf einer Folie in einem Transportgurt vorgesehen werden.

Bei einer weiteren Verfahrensvariante werden die Halbleiterchips in den Bauteilgruppen mit Flipchip-Kontakten ausgestattet. Die Herstellung von Verbindungen zwischen Halbleiterchip und dem Umverdrahtungssubstratstreifen wird auf der Oberseite des Umverdrahtungssubstratstreifens für Flipchip-Kontakte mittels eines Lötprozesses erfolgen. Ein derartiges Aufbringen von Halbleiterchips hat den Vorteil, dass auf eine Kunststoffeinbettung der Halbleiterchips mit Flipchip-Kontakten evtl. verzichtet werden kann. Darüber hinaus ist ein Lötprozess ein paralleler Fertigungsschritt, bei dem gleichzeitig eine Vielzahl von elektrischen Verbindungen zwischen einer Umverdrahtungsstruktur eines Umverdrahtungssubstratstreifens und Flipchip-Kontakten von Halbleiterchips hergestellt werden kann.

Eine weitere Verfahrensvariante sieht vor, dass die Halbleiterchips mit ihren Rückseiten auf die Halbleiterbauteilpositionen aufgebracht werden. Danach wird das Herstellen von Verbindungen zwischen den Halbleiterchips und einer Umverdrahtungsstruktur des Umverdrahtungssubstratstreifens mittels Bondtechnik durchgeführt. Bei diesem Verfahren werden Kontaktflächen auf der aktiven Oberseite des Halbleiterchips mit entsprechenden Kontaktanschlussflächen oder Bondfingern auf der Umverdrahtungsstruktur des Umverdrahtungssubstratstreifens mittels Bonddrähten hergestellt. Dieses ist ein serielles Verfahren, bei dem nacheinander eine Bondverbindung nach der anderen aufgebracht wird und die Bonddrähte anschließend in eine Kunststoffgehäusemasse mit den Halbleiterchips zusammen und unter Abdecken der Oberseite des Umverdrahtungssubstratstreifens erfolgt, um die Bondverbindungen vor Beschädigungen zu schützen.

Um die Prüfkontaktflächen und/oder die Außenkontaktflecken zu veredeln, können diese mit einer Goldlegierung selektiv beschichtet werden. Eine derartige selektive Beschichtung kann mittels Aufdampfen, Zerstäuben oder Sputtern unter Verspiegelung der gesamten Flächen einer Bauteilgruppe einer Umverdrahtungsstruktur erfolgen, nachdem vorher bereits eine strukturierte Fotolackschicht aufgebracht wurde. Anschließend wird die Goldschicht an Flächen, die nicht zu Vergolden sind, durch Abheben oder Aufquellen des Photolackes entfernt. Eine weitere Möglichkeit besteht darin, von vornherein eine Metallbeschichtung auf dem Substratstreifen vorzusehen, die eine Grundmetallisierung beispielsweise aus Kupfer aufweist, und eine Beschichtung aus einer Goldlegierung besitzt, um anschließend durch entsprechende Photolithographieschritte diese mehrlagige Metallschicht mittels Nassätzen oder Plasmaabtragen zu strukturieren.

Wenn für die vorgesehenen Tests die Prüfflächen als solche nicht ausreichen für eine entsprechende Kontaktierung, so können in einer weiteren Durchführungsvariante des Verfahrens Lotbälle auf die Prüfkontakte aufgelötet werden, bevor die Tests durchzuführen sind. Die Kontaktierung der Lötbälle auf den Prüfkontaktflächen hat darüber hinaus den Vorteil, dass die Außenkontaktflächen und/oder die Außenkontakte des Produktgehäuses geschont werden.

Nachdem mit dem oben geschilderten Verfahren und/oder Verfahrensvarianten ein Umverdrahtungssubstratstreifen hergestellt und getestet wurde, kann ein Auftrennen des Umverdrahtungssubstratstreifens in einzelne Halbleiterbauteile erfolgen und sich ein Aussortieren der als defekt markierten Halbleiterbauteile anschließen.

Zusammenfassend ist festzustellen, dass bei dem erfindungsgemäßen Substratstreifen der noch verfügbare Platz innerhalb einer Bauteilgruppe für zusätzliche Prüfkontaktflächen oder Prüfkontakte genutzt wird. Dabei werden eigene Flächen direkt neben den Halbleiterbauteilen für die zusätzlichen Prüfkontakte und Prüfkontaktflächen vorgesehen. Dieser Teil des Umverdrahtungssubstratstreifens in Form von Sägestreifen wird durch zusätzliche Sägelinien oder Sägespuren beim Auftrennen des Umverdrahtungssubstratstreifens in einzelne Halbleiterbauteile entfernt. Durch eine Drehung der Halbleiterbauteile auf dem Umverdrahtungssubstratstreifen wird die zusätzlich nutzbare Fläche in den Sägestreifen dann auch auf eine zweite Richtung erweitert, sodass die verfügbare Fläche z.B. bei Halbleiterbauteilen mit Anschlüssen an zwei Kanten optimiert ist. Durch das Drehen der Halbleiterchips, sowie durch ein teilweises Verlegen von Testkontakten oder von Testkontaktflächen in den Bereich außerhalb der Bauteilgruppe wird die verfügbare Kontakt- und Verdrahtungsfläche auf die Testautomaten zugreifen können vergrößert.

Die Schritte zwischen den Bauteilzeilen und Bauteilspalten Sägestreifen für Prüfkontaktflächen und außerhalb der Bauteilgruppe Testkontaktflächen vorzusehen, können gemeinsam oder getrennt je nach Anforderungen an den Umverdrahtungssubstratstreifen und die Messtechnik eingesetzt werden.

Die Erfindung wird nun anhand der beigefügten Figuren näher erläutert.
- Figur 1: zeigt eine schematische Draufsicht auf einen Um- verdrahtungssubstratstreifen gemäß einer ersten Aus- führungsform der Erfindung,
- Figur 2: zeigt eine Prinzipskizze einer Anordnung von Prüfkon- taktflächen einer Bauteilgruppe eines Umverdrahtungs- substratstreifens gemäß einer zweiten Ausführungsform der Erfindung,
- Figur 3: zeigt eine schematische Drausicht auf einen Um- verdrahtungssubstratstreifen der zweiten Ausführungs- form der Erfindung gemäß Figur 2.

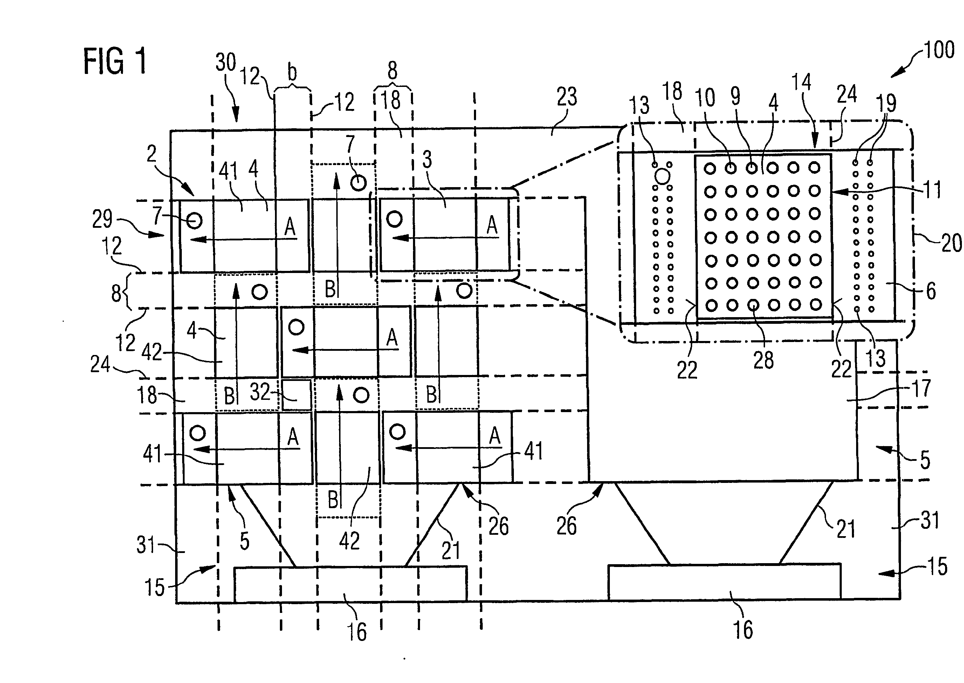

Figur 1 zeigt eine schematische Draufsicht auf einen Substratstreifen 23 eines Umverdrahtungssubstratstreifens 100 gemäß einer ersten Ausführungsform der Erfindung. Der rechte Teil der Draufsicht zeigt eine geschlossene Kunststoffabdeckung 17, die den Bereich 26 einer Bauteilgruppe 5 abdeckt. Die Details der Bauteilgruppe 5 werden in der linken Bildhälfte auf dem Umverdrahtungssubstratstreifen 100 gezeigt, wobei die Kunststoffabdeckung 17 weggelassen ist. In dieser ersten Ausführungsform der Erfindung sind unter der Kunststoffabdeckung 17 neun Halbleiterbauteile 3 angeordnet. Die Anordnung gliedert sich in drei Bauteilzeilen 29 und drei Bauteilspalten 30. Die neun Halbleiterbauteile 3 sind auf neun Halbleiterbauteilpositionen 2 angeordnet. Markierungspunkte 7 markieren die Ausrichtung der Halbleiterbauteile 3 in den Halbleiterbauteilpositionen 2, wobei zwischen einer ersten Ausrichtung A und einer um dazu um 90° gedrehten Ausrichtung B, zu unterscheiden ist.

Die Bezugszeichen 12 kennzeichnen Sägespuren, mit denen der Umverdrahtungssubstratstreifen 100 in einzelne Halbleiterbauteile 3 getrennt wird. Jeweils zwei Sägespuren 12 trennen aus dem Umverdrahtungssubstratstreifen 100 Sägestreifen 18 heraus. Diese weisen auf der Rückseite 6, welche der hier gezeigten Oberseite 31 des Umverdrahtungssubstratstreifens 100 gegenüber liegt, Prüfkontaktflächen 13 auf. In der Ausschnittsvergrößerung 20 am oberen rechten Bildrand wird ein Ausschnitt der Rückseite 6 einer Halbleiterbauteilposition. mit Sägestreifen 18 und Prüfkontaktflächen 13, die Prüfkontakte 19 tragen können, gezeigt.

Die linke Hälfte der Figur 1 zeigt die Bauteilgruppe ohne die Kunststoffabdeckung 17 und gibt damit einen Blick auf die Halbleiterchips 4 frei, die in dieser Ausführungsform der Erfindung quadratische Flächen aufweisen und mit Flipchip-Kontakten ausgestattet sein können. Jede Halbleiterbauteilposition 2 ist jedoch rechteckig, weil zu der Fläche der Halbleiterchips 4 noch Sägestreifenabschnitte auf zwei gegenüberliegenden Randseiten 22 der Halbleiterbauteile 3 hinzukommen. Diese rechteckige Fläche entspricht einem Debug-Gehäuse, während die quadratische Fläche in jeder der Halbleiterbauteilpositionen 2 die Größe eines Produktgehäuses kennzeichnet, das entsteht, wenn entlang der Sägespuren 12 der Umverdrahtungssubstratstreifen 100 auseinandergetrennt wird.

Durch den Bereich 8 der Sägestreifen 18 wird eine Fläche für Prüfkontaktflächen 13, wie sie in der Ausschnittsvergrößerung 20 zu sehen sind, bereit gestellt, die jedoch beim Auftrennen des Umverdrahtungssubstratstreifens 100 nicht zum Produktgehäuse gehören. Die Prüfkontaktflächen 13 auf der Rückseite 6, wie in der Ausschnittsvergrößerung 20 gezeigt, dienen dazu, die Funktionsfähigkeit der Halbleiterbauteile 3 bzw. der Halbleiterchips 4 zu testen, ohne dass die Außenkontakte 9 des Produktgehäuses auf der Rückseite 6 der Umverdrahtungssubstratstreifen 100 beschädigt werden.

Die Anordnungen in x- und y-Richtung einer Bauteilgruppe 5, wie sie auf der linken Hälfte der Figur 1 gezeigt werden, sind dadurch charakterisiert, dass die nächsten Nachbarn eines in einer ersten Ausrichtung A angeordneten Halbleiterbauteils eine um einheitlich 90° oder einheitlich um 270° gedrehte zweite Ausrichtung B aufweisen. In der ersten Ausführungsform der Figur 1 sind nur auf den Sägestreifenabschnitten zwischen den Produktionsgehäusen und nicht auf den Kreuzungsflächen 32 der Sägestreifen 18 Prüfkontaktflächen oder Prüfkontakte vorgesehen.

Diese erste Ausführungsform der Erfindung weist zusätzlich in einem Randbereich 15 des Umverdrahtungssubstratstreifens 100 eine Steckkontaktleiste 16 auf, die über eine Bündel 21 von Umverdrahtungsleitungen mit den Prüfkontaktflächen und/oder den Außenkontakten der Bauteilgruppe 5 elektrisch in Verbindung steht. Diese Steckkontaktleiste 16 dient dazu, Temperaturzyklentests, wie einen "burn-in"-Test, gleichzeitig für jeweils eine Bauteilgruppe 5 zu ermöglichen. Die Breite b eines Sägestreifens richtet sich danach, wie viele Reihen an Prüfkontaktflächen 13 für das Prüfen der Halbleiterchips 4 in den Halbleiterbauteilpositionen erforderlich sind.

In der Ausführungsform gemäß Figur 1 sind zwei Reihen Prüfkontaktflächen 13 auf den Sägestreifen 18 auf der Rückseite 6 des Umverdrahtungssubstratstreifens 100 vorgesehen, wie es in der Ausschnittsvergrößerung 20 gezeigt wird. Die Ausschnittsvergrößerung 20 zeigt weiterhin, dass die Außenkontakte 9 auf der Rückseite 6 des Umverdrahtungssubstratstreifens 100 in jeder der Halbleiterbauteilpositionen 2 in Außenkontaktzeilen 11 und Außenkontaktspalten 14 angeordnet sind. Ferner zeigt die Ausschnittsvergrößerung 20, dass die gesamte Unterseite des Produktgehäuses in einem vorgegebenem Rastermaß bei vorgegebener Schrittweite in Matrixform von Außenkontakten bedeckt ist. Die Außenkontakte 9 sind in dieser Ausführungsform der Erfindung auf Außenkontaktflecken 10 aufgelötete Lotbälle 28.

Die linke Hälfte der Figur 1 zeigt darüber hinaus, dass in den Bauteilzeilen 29 und den Bauteilspalten 30 jeweils auf den ungeraden Halbleiterbauteilpositionen 2 erste Halbleiterchips 4 mit der Ausrichtung A angeordnet sind, und auf geraden Halbleiterbauteilpositionen 2 zweite Halbleiterchips 42 mit der Ausrichtung B angeordnet sind. Diese Anordnung der Halbleiterbauteile ergibt ein Parallel- Stab Parkettmuster für die Debug-Gehäuse, wobei einerseits die quadratischen Kreuzungsflächen 32 mit der Randseite b charakteristisch sind und andererseits die größeren Rechteckflächen des jeweiligen zugehörigen Debug-Gehäuses das Parkettmuster kennzeichnen.

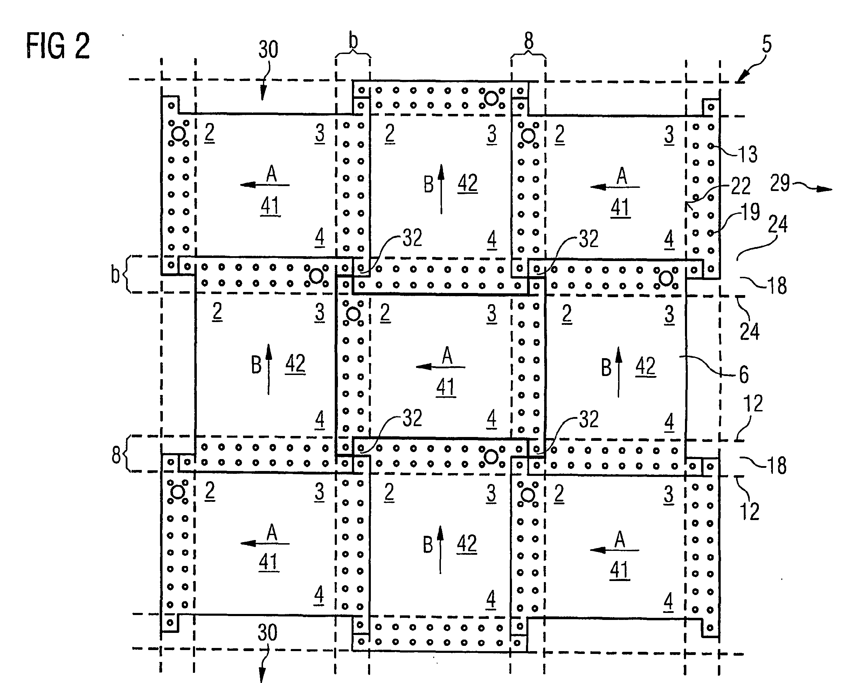

Figur 2 zeigt eine Prinzipskizze einer Anordnung von Prüfkontaktflächen 13 einer Bauteilgruppe 5 eines Umverdrahtungssubstratstreifens gemäß einer zweiten Ausführungsform der Erfindung. Komponenten mit gleichen Funktionen wie in Figur 1 werden mit gleichen Bezugszeichen gekennzeichnet und nicht extra erörtert.

In dieser zweiten Ausführungsform befinden sich die Prüfkontaktflächen 13 ebenfalls auf der Rückseite 6 eines Umverdrahtungssubstratstreifens. Die Prüfkontaktflächen 13 sind auf den Sägestreifen 18 mit der Breite b angeordnet. Die Außenkontur des Debug-Gehäuses ist jedoch nicht mehr rechteckförmig sondern Doppel-T-förmig. Durch diese spezielle Form des Debug-Gehäuses ist es möglich, die Kreuzungsflächen 32 der Sägestreifen 18 ebenfalls für das Anbringen von Prüfkontaktflächen 13 auszuschöpfen. Die Zuordnung der Prüfkontaktflächen 13 in den Kreuzungsflächen 32 ist so gestaltet, dass ein Viertel der Anzahl der Prüfkontaktflächen 13 in den Kreuzungsflächen 32 zu jeweils einem der benachbarten Debug-Gehäuse hinzukommt. Damit wird die Fläche der Sägestreifen optimal und vollständig für das Anordnen von Prüfkontaktflächen ausgenutzt. Die gegeneinander um 90° gedrehten Ausrichtungen A und B, sowie die alternierende Anordnung von ersten Halbleiterchips 41 und zweiten Halbleiterchips 42 in den Bauteilzeilen 29 und Bauteilspalten 30 wird wie in der ersten Ausführungsform beibehalten.

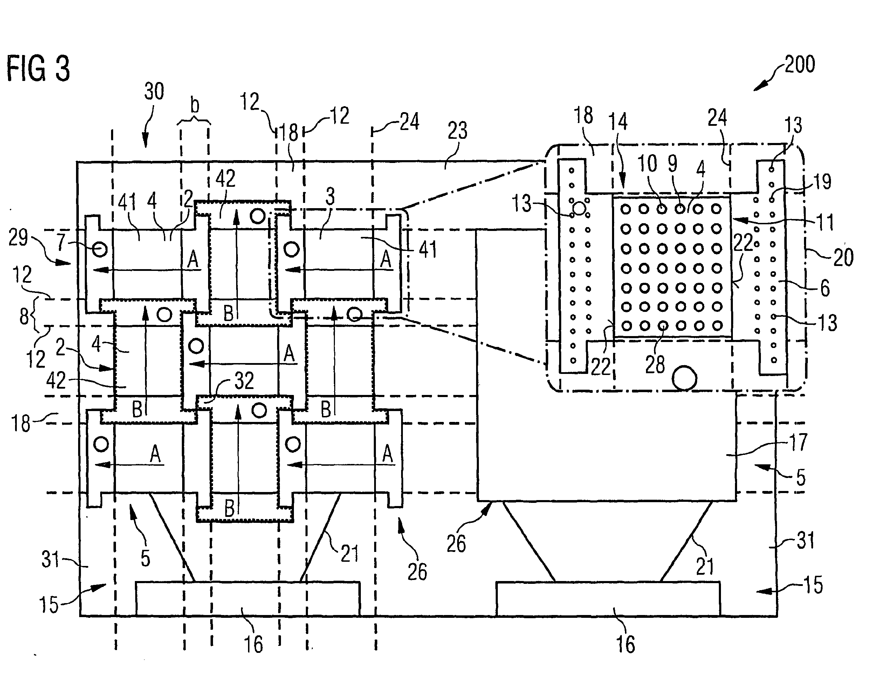

Figur 3 zeigt eine schematische Draufsicht auf einen Umverdrahtungssubstratstreifen 200 der zweiten Ausführungsform der Erfindung gemäß Figur 2. Komponenten mit gleichen Funktionen, wie in den vorhergehenden Figuren, werden mit gleichen Bezugszeichen gekennzeichnet und nicht extra erörtert.

Mit Figur 3 wird auf der linken Bildhälfte, die ohne Kunststoffabdeckung 17 dargestellt ist, die veränderte Außenkontur der Debug-Gehäuse gezeigt, die es ermöglicht, auch die Kreuzungsflächen 32 für das Anbringen von Prüfkontakten 13 zu nutzen. Die erste Ausrichtung A der ersten Halbleiterchips 41 und die zweite Ausrichtung B der zweiten Halbleiterchips 42 bleibt unverändert. Da die Debug-Gehäuse an sich nicht vereinzelt werden, sind weiterhin gerade Sägespuren 12 entlang der gestrichelten Linien 24 möglich, um aus dem Umverdrahtungssubstratstreifen 200 quadratische Halbleiterbauteile mit entsprechenden Außenkontakten 9 herauszusägen.

## Patentansprüche

1. Umverdrahtungssubstratstreifen mit mehreren Halbleiterbauteilpositionen (2) für Halbleiterbauteile (3), die in mehreren Bauteilzeilen (29) und Bauteilspalten (30) angeordnete Halbleiterchips (4) unterteilt durch Sägenspuren (12) angeordnet sind, wobei mehrere Halbleiterbauteilpositionen (2) zu einer Bauteilgruppe (5) zusammengefasst sind, wobei die Bauteilgruppe (5) mehrere Halbleiterchips (4) der Halbleiterbauteile (3) auf einer Oberseite (31) des Umverdrahtungssubstratstreifens (100) aufweist, und wobei innerhalb einer Bauteilgruppe (5) zwischen den Bauteilzeilen (29) und Bauteilspalten (30) Sägestreifen (18) vorgesehen sind, die Prüfkontaktflächen (13) aufweisen, wobei die Halbleiterbauteilpositionen (2) mit den Prüfkontaktflächen (13) derart zueinander ausgerichtet sind, dass sich ein Parkettierungsmuster gemäß einem Parallel-Stab Parkettmuster ergibt, **dadurch gekennzeichnet, dass** die Anordnungen von Außenkontakten (9) und Prüfkontaktflächen (13) auf der Rückseite (6) des Umverdrahtungssubstratstreifens (100) entsprechend zueinander in der Weise ausgerichtet sind, dass die Anordnungen von vier nächsten Nachbarn eines Halbleiterbauteils (3) um einheitlich 90° oder um einheitlich 270° gegenüber der einen Anordnung entsprechend einem vorgegebenen Plan gedreht sind.

2. Umverdrahtungssubstratstreifen nach Anspruch 1,
**dadurch gekennzeichnet, dass** die Bauteilzeilen (29) und Bauteilspalten (30) erste und zweite Halbleiterchips (41, 42) aufweisen, wobei sich die ersten und zweiten Halbleiterchips (41, 42) in ihren Ausrichtungen (A, B) unterscheiden, und wobei die ersten Halbleiterchips (41) eine erste Ausrichtung (A) aufweisen, und wobei die zweiten Halbleiterchips (42) einheitlich um 90° oder einheitlich um 270° gegenüber der ersten Ausrichtung A gedreht eine zweite Ausrichtung B aufweisen, und wobei die ersten und zweiten Halbleiterchips (41, 42) in den Bauteilzeilen (29) und Bauteilspalten (30) alternierend angeordnet sind.

3. Umverdrahtungssubstratstreifen nach Anspruch 1 oder Anspruch 2,
**dadurch gekennzeichnet, dass** auf einer der Oberseite (31) gegenüberliegenden Rückseite (6) des Umverdrahtungssubstratstreifens (100) in den Halbleiterbauteilpositionen (2) Außenkontakte (9) aufweisende Außenkontaktflecken (10) angeordnet sind und wobei die Außenkontaktflecken (10) über Umverdrahtungsleitungen mit den Prüfkontaktflächen (13), auf den Sägestreifen (18) elektrisch in Verbindung stehen.

4. Umverdrahtungssubstratstreifen nach einem der vorhergehenden Ansprüche,
**dadurch gekennzeichnet, dass** in den Halbleiterbauteilpositionen (2) die Prüfkontaktflächen (13) auf Sägestreifenabschnitten, die zu zwei gegenüberliegenden Randseiten (22) der Halbleiterbauteile (3) angeordnet sind, der jeweiligen Halbleiterbauteilposition (2) zugeordnet sind.

5. Umverdrahtungssubstratstreifen nach einem der vorhergehenden Ansprüche,
**dadurch gekennzeichnet, dass** die Sägestreifen (18) horizontal entlang der Bauteilzeilen (29) und vertikal entlang der Bauteilspalten (30) angeordnet sind und jeweils eine Kreuzungsfläche (32) bilden, die eine Anzahl von Prüfkontaktflächen (13) aufweist, wobei ein Viertel dieser Prüfkontaktflächen (13) auf einer Kreuzungsfläche (32) jeweils eine der vier angrenzenden Halbleiterbauteilpositionen (2) zugeordnet sind.

6. Umverdrahtungssubstratstreifen nach einem der vorhergehenden Ansprüche,
**dadurch gekennzeichnet, dass** eine oder mehrere Bauteilgruppen (5) auf dem Umverdrahtungssubstratstreifen (100) hintereinander und/oder nebeneinander aufgereiht sind, und vorzugsweise eine oder mehrere Kunststoffabdeckungen (17) aufweisen.

7. Umverdrahtungssubstratstreifen nach einem der vorhergehenden Ansprüche,
**dadurch gekennzeichnet, dass** in den Halbleiterbauteilpositionen (2) Außenkontakte (9) aufweisende Außenkontaktflecken (10) in einer Außenkontaktfleckenmatrix mit Außenkontaktzeilen (11) und Außenkontaktspalten (14) angeordnet sind.

8. Umverdrahtungssubstratstreifen nach einem der vorhergehenden Ansprüche,
**dadurch gekennzeichnet, dass** die Halbleiterchips (4) über Flipchip-Kontakte oder über Bonddrahtverbindungen elektrisch mit dem Umverdrahtungssubstratstreifen (100) in Verbindung stehen.

9. Umverdrahtungssubstratstreifen nach einem der vorhergehenden Ansprüche,
**dadurch gekennzeichnet, dass** der Umverdrahtungssubstratstreifen (100) auf seiner Rückseite (6) außerhalb des Bereichs (26) einer Bauteilgruppe (5) Bereiche mit freiliegenden Testkontaktflächen aufweist, wobei die Testkontaktflächen über Umverdrahtungsleitungen mit den Prüfkontaktflächen (13) in den Sägestreifen (18) und/oder den Außenkontaktflecken (10) der Halbleiterbauteile (3) elektrisch in Verbindung stehen.

10. Umverdrahtungssubstratstreifen nach einem der vorhergehenden Ansprüche,
**dadurch gekennzeichnet, dass** der Umverdrahtungssubstratstreifen (100) in einem Randbereich (15) eine Steckkontaktleiste (16) mit Steckkontaktflächen aufweist, wobei die Steckkontaktflächen mit den Prüfkontaktflächen (13) und/oder mit Testkontaktflächen und/oder den Außenkontaktflecken (10) elektrisch in Verbindung stehen.

11. Umverdrahtungssubstratstreifen nach Anspruch 10,
**dadurch gekennzeichnet, dass** die Steckkontaktleiste (16) des Umverdrahtungssubstratstreifens (100) für einen Temperaturzyklentest bzw. "burn-in" Test vorgesehen ist.

12. Umverdrahtungssubstratstreifen nach einem der vorhergehenden Ansprüche,
**dadurch gekennzeichnet, dass** die Prüfkontaktflächen (13) Prüfkontakte (19) tragen.

13. Umverdrahtungssubstratstreifen nach einem der vorhergehenden Ansprüche,
**dadurch gekennzeichnet, dass** die Prüfkontaktflächen (13) eine Goldbeschichtung aufweisen.

14. Umverdrahtungssubstratstreifen nach einem der vorhergehenden Ansprüche,
**dadurch gekennzeichnet, dass** der Umverdrahtungssubstratstreifen (100) in den Halbleiterbauteilpositionen (2), Stapel aus einem Logikchip und einem Speicherchip aufweist, wobei über die Prüfkontaktflächen (13) und/oder über freiliegende Testkontaktflächen und/oder über Prüfkontakte (19) und/oder über Steckkontaktleisten (16), sowohl die Speicherfunktionen des Speicherchips, als auch die Logikfunktionen des Logikchips prüfbar sind.

15. Verfahren zur Herstellung eines Umverdrahtungssubstratstreifen (100) mit mehreren Bauteilgruppen (5), wobei die Bauteilgruppen (5) in x-Richtung in Bauteilzeilen (29) und in y-Richtung in Bauteilspalten (30) angeordnete Halbleiterbauteilpositionen (2) mit Halbleiterchips (4) aufweisen, und wobei das Verfahren folgende Verfahrensschritte aufweist:
- Bereitstellen eines auf seiner Rückseite (6) metallbeschichteten Substratstreifens (23),
- Aufbringen einer Umverdrahtungsstruktur auf dem metallbeschichteten Substratstreifen (23), wobei die Umverdrahtungsstruktur Außenkontaktflecken (10) in den Halbleiterbauteilpositionen (2) und Prüfkontaktflächen (13) im Bereich (8) von Sägestreifen (18) zwischen den Halbleiterbauteilpositionen (2) aufweist,
- Aufbringen von Halbleiterchips (4) auf die Oberseite (31) des Umverdrahtungssubstratstreifens (100) in den Halbleiterbauteilpositionen (2), in der Weise, dass zunächst jede ungerade Halbleiterbauteilposition (2) in den Bauteilzeilen (29) und den Bauteilspalten (30) mit einem ersten Halbleiterchip (41) in einer ersten Ausrichtung (A) bestückt wird und anschließend die verbliebenen geraden Halbleiterbauteilpositionen (2) mit einem zweiten Halbleiterchip (42) in einer zweiten gegenüber der ersten Ausrichtung (A) einheitlich um 90° oder einheitlich um 270° verdrehten zweiten Ausrichtung (B) bestückt werden, sodass ein Stab Parkettmuster nach vorgegebenem Plan in x- und y-Richtung gebildet wird,
- Herstellen von Verbindungen zwischen den Halbleiterchips (4) und der Umverdrahtungsstruktur,
- Aufbringen von Außenkontakten (9) in den Halbleiterbauteilpositionen (2) auf die Außenkontaktflecken (10) der Umverdrahtungsstruktur auf der Rückseite (6) des Umverdrahtungssubstratstreifens (100),
- Durchführen von Funktionstests der in Bauteilgruppen (5) zusammengefassten Halbleiterchips (4) unter Kontaktieren der Prüfkontaktflächen (13),
- Markieren von defekten Halbleiterbauteilen (3) auf dem Umverdrahtungssubstratstreifen (100).

16. Verfahren nach Anspruch 15,
**dadurch gekennzeichnet, dass** die Halbleiterchips (4) gleichförmig und einheitlich ausgerichtet auf die Oberseite (31) des Umverdrahtungssubstratstreifens (100) aufgebracht werden und eine Umverdrahtungsstruktur auf dem Umverdrahtungsleitungen vorgesehen wird, wie in den Halbleiterbauteilpositionen (2) des Umverdrahtungssubstratstreifens (100) eine Ausrichtung der Anordnung von Außenkontakten (9) gegenüber der Ausrichtung der Halbleiterchips in den Bauteilzeilen (29) und den Bauteilspalten (30) für ungerade Halbleiterbauteilpositionen (2) einheitlich eine um 0° und/oder 180° und für gerade Halbleiterbauteilpositionen (2) eine gegenüber der Ausrichtung der Halbleiterchips einheitlich um 90° und/oder einheitlich um 270° verdrehte Ausrichtung vorsieht, sodass die vorgegebene Rotation in den Halbleiterbauteilpositionen (2) mittels eines vorgegebenen Umverteilungsplanes für einen mehrlagigen Umverdrahtungssubstratstreifen (100) durchgeführt wird.

17. Verfahren nach Anspruch 15,
**dadurch gekennzeichnet, dass** zum Aufbringen von unterschiedlich ausgerichteten und angeordneten Halbleiterchips (4) auf dem Umverdrahtungssubstratstreifen (100) ein in Halbleiterchips (4) getrennter Wafer zur Verfügung steht, der in x- und y-Anordnung, sowie in Rotationsausrichtung vorbereitend ausgerichtete und angeordnete Halbleiterchips (4) aufweist, die von einem Bestückungsautomaten in dieser vorgegebenen Anordnung und Ausrichtung des Wafers auf die Oberseite (31) des Umverteilungssubstratstreifens (100) aufgebracht werden.

18. Verfahren nach Anspruch 15,
**dadurch gekennzeichnet, dass** zum Aufbringen von unterschiedlich ausgerichteten und angeordneten Halbleiterchips (4) auf dem Umverdrahtungssubstratstreifen (100) eine Folie mit Halbleiterchips (4) zur Verfügung steht, die in x- und y-Anordnung sowie in Rotationsausrichtung vorbereitend ausgerichtete und angeordnete Halbleiterchips (4) aufweist, die von einem Bestückungsautomaten in dieser vorgegebenen Anordnung und Ausrichtung auf die Oberseite (31) des Umverteilungssubstratstreifens (100) aufgebracht werden.

19. Verfahren nach Anspruch 15,
**dadurch gekennzeichnet, dass** zum Aufbringen von unterschiedlich ausgerichteten und angeordneten Halbleiterchips (4) auf dem Umverdrahtungssubstratstreifen (100) ein in x-, y-Anordnung und Rotationsausrichtung programmierbarer Bestückungsautomat eingesetzt wird, der einheitlich angeordnete und gleichförmig ausgerichtete Halbleiterchips (4) von einem in Halbleiterchips (4) getrennten Wafer oder von einer einheitlich mit Halbleiterchips (4) bestückten Folie aufnimmt und der den vorgesehenen Anordnungs- und Ausrichtungsplan beim Bestücken des Umverdrahtungssubstratstreifens (100) programmgemäß durchgeführt.

20. Verfahren nach einem der Ansprüche 15 bis 19,
**dadurch gekennzeichnet, dass** die Halbleiterchips (4) in den Bauteilgruppen (5) Halbleiterchips (4) mit Flipchip-Kontakten sind und die Herstellung von Verbindungen zwischen Halbleiterchips (4) und einer Umverdrahtungsstruktur auf der Oberseite (31) des Umverdrahtungssubstratstreifens (100) mittels eines Lötprozesses erfolgt.

21. Verfahren nach einem der Ansprüche 15 bis 19,
**dadurch gekennzeichnet, dass** die Halbleiterchips (4) mit ihren Rückseiten auf die Halbleiterbauteilpositionen (2) aufgebracht werden, und das Herstellen von Verbindungen zwischen Halbleiterchips (4) und einer Umverdrahtungsstruktur auf der Oberseite (31) des Umverdrahtungssubstratstreifens (100) mittels Bondtechnik erfolgt.

22. Verfahren nach einem der Ansprüche 15 bis 21,
**dadurch gekennzeichnet, dass** auf die Bauteilgruppen (5) nach dem Herstellen der Verbindungen zwischen Halbleiterchips (4) und Umverdrahtungssubstratstreifen (100) Kunststoffabdeckungen (17) aufgebracht werden, welche die Halbleiterchips (4) in eine Kunststoffmasse einbetten.

23. Verfahren nach einem der Ansprüche 15 bis 22,
**dadurch gekennzeichnet, dass** die Prüfkontaktflächen (13) und/oder die Außenkontaktflecken (10) der Umverdrahtungsstruktur mit einer Goldlegierung selektiv beschichten werden.

24. Verfahren nach einem der Ansprüche 15 bis 23,
**dadurch gekennzeichnet, dass** auf die Prüfkontaktflächen (13) Lotbälle (28) als Prüfkontakte (19) aufgelötet werden.

25. Verfahren zur Herstellung von Halbleiterbauteilen (3), das nachfolgende Verfahrensschritte aufweist:
- Herstellen eines Umverdrahtungssubstratstreifens (100) nach einem der Ansprüche 15 bis 24,
- Auftrennen des Umverdrahtungssubstratstreifens (100) in einzelne Bauteile und
- Aussortieren der als defekt markierten Halbleiterbauteile (3).

## Claims

1. A rewiring substrate strip with several semiconductor component positions (2) for semiconductor components (3) which are arranged in semiconductor chips (4) arranged in several component rows (29) and component columns (30) subdivided by cutting lines (12), wherein several semiconductor components positions (2) are combined to form one component group (5), the component group (5) comprising several semiconductor chips (4) of the semiconductor components (3) on a top side (31) of the rewiring substrate strip (100), and wherein cutting strips (18) which have test contact surfaces (13) are provided between the component rows (29) and component columns (30) within a component group (5), the semiconductor component positions (2) and the test contact surfaces (13) being aligned with respect to one another in such a manner that a parketting pattern according to a parallel-rod Parquet pattern is produced, **characterized in that** the arrangements of external contacts (9) and test contact surfaces (13) on the rear side (6) of the rewiring substrate strip (100) are correspondingly aligned with respect to one another in such a manner that the arrangements of four next neighbors of a semiconductor component (3) are rotated by uniformly 90° or by uniformly 270° with respect to the one arrangement in accordance with a predetermined plan.

2. The rewiring substrate strip according to claim 1, **characterized in that** the component rows (29) and component columns (30) comprise first and second semiconductor chips (41, 42), the first and second semiconductor chips (41, 42) differing in their alignments (A, B) and the first semiconductor chips (41) having a first alignment (A) and the second semiconductor chips (42) having a second alignment (B) rotated uniformly by 90° or uniformly by 270° with respect to the first alignment A, and the first and second semiconductor chips (41, 42) being arranged alternately in the component rows (29) and component columns (30).

3. The rewiring substrate strip according to claim 1 or claim 2, **characterized in that** on a rear side (6), opposite to the top side (31), of the rewiring substrate strip (100) external contact patches (10) having external contacts (9) are arranged in the semiconductor component positions (2) and wherein the external contact patches (10) are electrically connected to the test contact surfaces (13) on the cutting strips (18) via rewiring lines.

4. The rewiring substrate strip according to one of the preceding claims, **characterized in that** in the semiconductor component positions (2), the test contact surfaces (13) on cutting strip sections which are arranged at two opposite edges (22) of the semiconductor components (3) are allocated to the respective semiconductor component position (2).

5. The rewiring substrate strip according to one of the preceding claims, **characterized in that** the cutting strips (18) are arranged horizontally along the component rows (29) and vertically along the component columns (30), and in each case form an intersection area (32) which comprises a number of test contact surfaces (13), a quarter of these test contact surfaces (13) on an intersection area (32) in each case being allocated to one of the four adjoining semiconductor component positions (2).

6. The rewiring substrate strip according to one of the preceding claims, **characterized in that** one or more component groups (5) are arranged in a row behind one another and/or next to one another on the rewiring
substrate strip (100) and preferably have one or more plastic covers (17).

7. The rewiring substrate strip according to one of the preceding claims, **characterized in that** in the semiconductor component positions (2), external contact patches (10) having external contacts (9) are arranged in an external contact patch matrix with external contact rows (11) and external contact columns (14).

8. The rewiring substrate strip according to one of the preceding claims, **characterized in that** the semiconductor chips (4) are electrically connected to the rewiring substrate strip (100) via flip chip contacts or via bonding wire connections.

9. The rewiring substrate strip according to one of the preceding claims, **characterized in that** the rewiring substrate strip (100) has on its rear side (6), outside the area (26) of a component group (5), areas with exposed test contact surfaces, the test contact surfaces being electrically connected to the test contact surfaces (13) in the cutting strips (18) and/or the external contact patches (10) of the semiconductor components (3) via rewiring lines.

10. The rewiring substrate strip according to one of the preceding claims, **characterized in that** the rewiring substrate strip (100) has in an edge area (15) a plug-in contact strip (16) with plug-in contact surfaces, the plug-in contact surfaces being electrically connected to the test contact surfaces (13) and/or to test contact surfaces and/or the external contact patches (10).

11. The rewiring substrate strip according to claim 10, **characterized in that** the plug-in contact strip (16) of the rewiring substrate strip (100) is provided for a temperature cycle test or, respectively, "burn-in" test.

12. The rewiring substrate strip according to one of the preceding claims, **characterized in that** the test contact surfaces (13) carry test contacts (19).

13. The rewiring substrate strip according to one of the preceding claims, **characterized in that** the test contact surfaces (13) comprise gold plating.

14. The rewiring substrate strip according to one of the preceding claims, **characterized in that** the rewiring substrate strip (100) has in the semiconductor component positions (2) stacks of a logic chip and a memory chip, wherein both the memory functions of the memory chip and the logic functions of the logic chip can be tested via test contact surfaces (13) and/or via exposed test contact surfaces and/or via test contacts (19) and/or via plug-in contact strips (16).

15. A method for producing a rewiring substrate strip (100) with several component groups (5), wherein the component groups (5) comprise semiconductor component positions (2) with semiconductor chips (4), the semiconductor component positions (2) being arranged in component rows (29) in the x-direction and in component columns (30) in the y-direction, and wherein the method comprises the following method steps;
- providing a substrate strip (23) which is metal-plated on its rear side (6),
- applying a rewiring structure on the metal-plated substrate strip (23), the rewiring structure comprising external contact patches (10) in the semiconductor component positions (2) and test contact surfaces (13) in the area (8) of cutting strips (18) between the semiconductor component positions (2),
- mounting semiconductor chips (4) on the top side (31) of the rewiring substrate strip (100) in the semiconductor component positions (2), in such a manner that first each odd-numbered semiconductor component position (2) in the component rows (29) and component columns (30) is equipped with a first semiconductor chip (41) in a first alignment (A) and then the remaining even-numbered semiconductor component positions (2) are equipped with a second semiconductor chip (42) in a second alignment (B) which is rotated uniformly by 90° or uniformly by 270° with respect to the first alignment (A), so that a rod-Parquet pattern is formed in accordance with a predetermined plan in the x- and y-direction,
- producing connections between the semiconductor chips (4) and the rewiring structure,
- applying external contacts (9) in the semiconductor component positions (2) to the external contact patches (10) of the rewiring structure on the rear side (6) of the rewiring substrate strip (100),
- performing functional tests of the semiconductor chips (4), combined into component groups (5), by contacting the test contact surfaces (13),
- marking defective semiconductor components (3) on the rewiring substrate strip (100).

16. The method according to claim 15, **characterized in that** the semiconductor chips (4) are mounted uniformly and with standard alignment on the top side (31) of the rewiring substrate strip (100) and a rewiring structure is provided on the rewiring lines which provides in the semiconductor component positions (2) of the rewiring substrate strip (100) an alignment of the arrangement of external contacts (9) which is rotated uniformly by 0° and/or 180° for odd-numbered semiconductor component positions (2) with respect to the alignment of the semiconductor chips in the component rows (29) and the component columns (30) and rotated uniformly by 90° and/or uniformly by 270° with respect to the alignment of the semiconductor chips for even-numbered semiconductor component positions (2), so that the predetermined rotation in the semiconductor component positions (2) is carried out by means of a predetermined redistribution plan for a multi-layered rewiring substrate strip (100).

17. The method according to claim 15, **characterized in that**, for mounting differently aligned and arranged semiconductor chips (4) on the rewiring substrate strip (100), a wafer separated into semiconductor chips (4) is available which comprises semiconductor chips (4) aligned and arranged in a preparatory manner in an x-and y-arrangement and in rotational alignment, which are mounted on the top side (31) of the rewiring substrate strip (100) in this predetermined arrangement and alignment of the wafer by an automatic insertion machine.

18. The method according to claim 15, **characterized in that**, for mounting differently aligned and arranged semiconductor chips (4) on the rewiring substrate strip (100), a foil with semiconductor chips (4) is available which comprises semiconductor chips (4) aligned and arranged in a preparatory manner in the x- and y-arrangement and in rotational alignment, which are mounted on the top side (31) of the rewiring substrate strip (100) in this predetermined arrangement and alignment by an automatic insertion machine.

19. The method according to claim 15, **characterized in that**, for mounting differently aligned and arranged semiconductor chips (4) on the rewiring substrate strip (100), an automatic insertion machine which is programmable in x-, y-arrangement and rotational alignment, is used which picks up semiconductor chips (4) arranged in standard manner and uniformly aligned from a wafer separated into semiconductor chips (4) or from a foil uniformly equipped with semiconductor chips (4) and which carries out the provided arrangement and alignment plan according to program during the equipping of the rewiring substrate strip (100).

20. The method according to one of claims 15 to 19, **characterized in that** the semiconductor chips (4) in the component groups (5) are semiconductor chips (4) with flip chip contacts and connections between semiconductor chips (4) and a rewiring structure are established on the top side (31) of the rewiring substrate strip (100) by means of a soldering process.

21. The method according to one of claims 15 to 19, **characterized in that** the semiconductor chips (4) are mounted with their rear sides on the semiconductor component positions (2) and connections between semiconductor chips (4) and a rewiring structure on the top side (31) of the rewiring substrate strip (100) are established by means of bonding technology.

22. The method according to one of claims 15 to 21, **characterized in that**, after the connections are established between semiconductor chips (4) and rewiring substrate strip (100), plastic covers (17) are applied to the component groups (5) which embed the semiconductor chips (4) in a plastic compound.

23. The method according to one of claims 15 to 22, **characterized in that** the test contact surfaces (13) and/or the external contact patches (10) of the rewiring structure are selectively plated with a gold alloy.

24. The method according to one of claims 15 to 23, **characterized in that** solder balls (28) are soldered to the test contact surfaces (13) as test contacts (19).

25. A method for producing semiconductor components (3) which comprises the following method steps:
- producing a rewiring substrate strip (100) according to one of claims 16 to 25,
- separating the rewiring substrate strip (100) into individual components and,
- sorting out the semiconductor components (3) marked as defective.

## Revendications

1. Bande de substrat de recâblage ayant plusieurs positions (2) de composants à semiconducteurs pour des composants (3) à semiconducteurs, qui sont subdivisés par des traits (12) de scie en des puces (4) à semiconducteurs disposées en plusieurs lignes (29) de composants et colonnes (30) de composants, plusieurs positions (2) de composants à semiconducteurs étant rassemblées en un groupe (5) de composants, le groupe (5) de composants comportant plusieurs puces (4) à semiconducteurs des composants (3) à semiconducteurs sur une face (31) supérieure de la bande (100) de substrat de recâblage, et dans lequel, à l'intérieur d'un groupe (5) de composants, il est prévu entre les lignes (29) de composants et les colonnes (30) de composants des stries (18) de scie, qui ont des surfaces (13) de contact de contrôle, les positions (2) de composants à semiconducteurs avec les surfaces (13) de contact de contrôle étant orientées les unes par rapport aux autres, de manière à obtenir un modèle de mosaïque selon un modèle de mosaïque à barres parallèles, **caractérisée en ce que**
les agencements de contact (9) extérieurs et de surfaces (13) de contact de contrôle sont orientés sur la face (6) arrière de la bande (100) de substrat de recâblage en se correspondant les uns avec les autres, de manière à ce que les agencements de quatre voisins les plus proches d'un composant (3) à semiconducteurs soient tournés conformément à un plan prescrit d'une manière unitaire de 90° ou d'une manière unitaire de 270° par rapport à un agencement.

2. Bande de substrat de recâblage suivant la revendication 1, **caractérisée en ce que**
les lignes (29) de composants et les colonnes (30) de composants comportent des premières et deuxièmes puces (41, 42) à semiconducteurs, les premières et deuxièmes puces (41, 42) à semiconducteurs différant dans leur orientation (A, B) et les premières puces (41) à semiconducteurs ayant une première orientation (A) et les deuxièmes puces (42) à semiconducteurs ayant une deuxième orientation B tournée d'une manière unitaire de 90° ou d'une manière unitaire de 270° par rapport à la première orientation A et les premières et deuxièmes puces (41, 42) à semiconducteurs étant disposées en alternance dans les lignes (29) de composants et les colonnes (30) de composants.

3. Bande de substrat de recâblage suivant la revendication 1 ou 2,
**caractérisée en ce que**
sur une face (6) arrière opposée à la face (31) supérieure de la bande (100) de substrat de recâblage sont disposées dans les positions (2) de composants à semiconducteurs des plages (10) de contact extérieur ayant des contacts (9) extérieurs et les plages (10) de contact extérieur sont sur les stries (18) de scie en liaison électrique avec les surfaces (13) de contact de contrôle par des lignes de recâblage.

4. Bande de substrat de recâblage suivant l'une des revendications précédentes,
**caractérisée en ce que**
dans les positions (2) de composants à semiconducteurs, les surfaces (13) de contact de contrôle sont associées à la position (2) respective de composants à semiconducteurs sur des segments de stries de scie, qui sont disposés sur deux côtés (22) latéraux opposés des composants (3) à semiconducteurs.

5. Bande de substrat de recâblage suivant l'une des revendications précédentes,
**caractérisée en ce que**
les stries (18) de scie sont disposées horizontalement le long des lignes (29) de composants et verticalement le long des colonnes (30) de composants et forment respectivement une surface (32) d'intersection, qui a un certain nombre de surfaces (13) de contact de contrôle, un quart de ces surfaces (13) de contact de contrôle étant associé sur une surface (32) d'intersection à respectivement l'une des quatre positions (2) de composants à semiconducteurs voisines.

6. Bande de substrat de recâblage suivant l'une des revendications précédentes,
**caractérisée en ce que**
un ou plusieurs groupes (5) de composants sont rangés l'un derrière l'autre et/ou l'un à côté de l'autre sur la bande (100) de substrat de recâblage et ont, de préférence, un ou plusieurs recouvrements (17) en matière plastique.

7. Bande de substrat de recâblage suivant l'une des revendications précédentes,
**caractérisée en ce que**
dans les positions (2) de composants à semiconducteurs, des plages (10) de contact extérieur ayant des contacts (9) extérieurs sont disposées suivant une matrice de plage de contact extérieur ayant des lignes (11) de contact extérieur et des colonnes (14) de contact extérieur.

8. Bande de substrat de recâblage suivant l'une des revendications précédentes,
**caractérisée en ce que**
les puces (4) à semiconducteurs sont en liaison électriquement avec la bande (100) de substrat de recâblage par des contacts flipchip ou par des liaisons à fil de liaison.

9. Bande de substrat de recâblage suivant l'une des revendications précédentes,
**caractérisée en ce que**
la bande (100) de substrat de recâblage a sur sa face (6) arrière à l'extérieur de la zone (26) d'un groupe (5) de composants des zones ayant des surfaces de contact de test dénudées, les surfaces de contact de test étant en liaison électriquement par des lignes de recâblage avec les surfaces (13) de contact de test dans les stries (18) de scie et/ou dans les plages (10) de contact extérieur des composants (3) à semiconducteurs.

10. Bande de substrat de recâblage suivant l'une des revendications précédentes,
**caractérisée en ce que**
la bande (100) de substrat de recâblage a dans une zone (15) de bord une réglette (16) de contact à enfichage ayant des surfaces de contact à enfichage, les surfaces de contact à enfichage étant en liaison électriquement avec les surfaces (13) de contact de contrôle et/ou avec les surfaces de contact de test et/ou avec les plages (10) de contact extérieur.

11. Bande de substrat de recâblage suivant la revendication 10,
**caractérisée en ce que**
la réglette (16) de contact à enfichage de la bande (100) de substrat de recâblage est prévue pour un test de cycle de température ou bien pour un test de "burn-in",

12. Bande de substrat de recâblage suivant l'une des revendications précédentes,
**caractérisée en ce que**
les surfaces (13) de contact de contrôle portent des contacts (19) de contrôle.

13. Bande de substrat de recâblage suivant l'une des
revendications précédentes,
**caractérisée en ce que**
les surfaces (13) de contact de contrôle ont un revêtement en or.

14. Bande de substrat de recâblage suivant l'une des revendications précédentes,
**caractérisée en ce que**
la bande (100) de substrat de recâblage a, dans les positions (2) de composants à semiconducteurs, un empilement composé d'une puce logique et d'une puce de mémoire, dans laquelle par les surfaces (13) de contact de contrôle et/ou par les surfaces de contact de test dénudées et/ou par les contacts (19) de contrôle et/ou par les réglettes (16) de contact à enfichage, tant les fonctions de mémoire de la puce de mémoire qu'également les fonctions logiques de la puce logique peuvent être contrôlées.

15. Procédé de production d'une bande (100) de substrat de recâblage ayant plusieurs groupes (5) de composants, les groupes (5) de composants comportant des positions (2) de composants à semiconducteurs à puces (4) à semiconducteurs disposés dans la direction x en des lignes (29) de composants et dans la direction y en des colonnes (30) de composants, le procédé comportant les stades suivants :
- on se procure une bande (23) de substrat revêtue de métal sur sa face (6) arrière,
- on dépose une structure de recâblage sur la bande (23) de substrat revêtue de métal, la structure de recâblage ayant des plages (10) de contact extérieur dans les positions (2) de composants à semiconducteurs et des surfaces (13) de contact de contrôle dans la zone de stries (18) de scie entre les positions (2) de composants à semiconducteurs,
- on dépose des puces (4) à semiconducteurs sur la face (31) supérieure de la bande (100) de substrat de recâblage dans les positions (2) de composants à semiconducteurs, de manière à pourvoir d'abord chaque position (2) impaire de composants à semiconducteurs dans les lignes (29) de composants et dans les colonnes (30) de composants d'une première puce (41) à semiconducteurs suivant une première orientation (A) et ensuite à pourvoir les positions (2) paires restantes de composants à semiconducteurs d'une deuxième puce (42) à semiconducteurs dans une deuxième orientation (B), tournée par rapport à la première orientation (A) d'une manière unitaire de 90° ou d'une manière unitaire de 270°, de manière à former une barre d'un modèle de mosaïque suivant un plan prescrit dans la direction x et dans la direction y,
- on ménage des liaisons entre les puces (4) à semiconducteurs et la structure de recâblage,
- on dépose des contacts (9) extérieurs dans les positions (2) de composants à semiconducteurs sur les plages (10) de contact extérieur de la structure de recâblage sur la face (6) arrière de la bande (100) de substrat de recâblage,
- on effectue des tests de fonction des puces (4) à semiconducteurs rassemblées en groupes (5) de composants en mettant en contact les surfaces (13) de contact de contrôle,
- on repère des composants (3) à semiconducteurs défectueux sur la bande (100) de substrat de recâblage.

16. Procédé suivant la revendication 15,
**caractérisé en ce que**
les puces (4) à semiconducteurs sont déposées uniformément en étant dirigées d'une manière unitaire sur la face (31) supérieure de la bande (100) du substrat de recâblage et il est prévu une structure de recâblage sur les lignes de recâblage, comme dans les positions (2) de composants à semiconducteurs de la bande (100) du substrat de recâblage, une orientation de l'agencement des contacts (9) extérieurs par rapport à l'orientation des puces à semiconducteurs dans les lignes (29) de composants et les colonnes (30) de composants prévoit pour des positions (2) impaires de composants à semiconducteurs unitairement une orientation tournée de 0° et/ou de 180° et pour des positions (2) paires de composants à semiconducteurs une orientation tournée d'une manière unitaire de 90° et/ou d'une manière unitaire de 270° par rapport à l'orientation des puces à semiconducteurs, de sorte que la rotation prescrite des positions (2) de composants à semiconducteurs est effectuée pour une bande (100) de substrat de recâblage à plusieurs couches au moyen d'un plan de recâblage prescrit.

17. Procédé suivant la revendication 15,
**caractérisé en ce que**
pour le dépôt de puces (4) à semiconducteurs orientées différemment et disposées différemment sur la bande (100) du substrat de recâblage, une tranche séparée dans les puces (4) à semiconducteurs est à disposition, tranche qui comporte des puces (4) à semiconducteurs orientées et disposées d'une manière préparatoire dans l'agencement x et y ainsi que dans l'orientation en rotation, puces qui sont déposées sur la face (31) supérieure de la bande (100) du substrat de recâblage par un automate d'implantation dans ces agencement et orientation prescrits de la tranche.

18. Procédé suivant la revendication 15,
**caractérisé en ce que**
pour le dépôt de puces (4) à semiconducteurs orientées et disposées différemment sur la bande (100) du substrat de recâblage, il est mis à disposition une feuille ayant des puces (4) à semiconducteurs, qui comporte des puces (4) à semiconducteurs orientées et disposées de manière préparatoire dans l'agencement x et y ainsi que dans l'orientation en rotation, puces qui sont déposées sur la face (31) supérieure de la bande (100) du substrat de recâblage par un automate d'implantation dans cet agencement et orientation prescrits.

19. Procédé suivant la revendication 15,
**caractérisé en ce que**
pour le dépôt de puces (4) à semiconducteurs orientées et disposées différemment sur la bande (100) du substrat de
recâblage, on utilise un automate d'implantation programmable dans l'agencement x, y et dans l'orientation en rotation, automate qui reçoit des puces (4) à semiconducteurs disposées de manière unitaire et orientées uniformément d'une tranche séparée dans des puces (4) à semiconducteurs ou d'une feuille pourvue unitairement de puces (4) à semiconducteurs et qui effectue suivant le programme le plan prévu d'agencement et d'orientation de l'implantation sur la bande (100) du substrat de recâblage.

20. Procédé suivant l'une des revendications 15 à 19, **caractérisé en ce que**
les puces (4) à semiconducteurs dans les groupes (5) de composants sont des puces (4) à semiconducteurs ayant des contacts flipchip et la production de liaison entre des puces (4) à semiconducteurs et une structure de recâblage sur la face (31) supérieure de la bande (100) du substrat de recâblage s'effectue au moyen d'un processus de soudure.

21. Procédé suivant l'une des revendications 15 à 19, **caractérisé en ce que**
les puces (4) à semiconducteurs sont déposées par leur face arrière sur les positions (2) de composants à semiconducteurs et la production de liaison entre des puces (4) à semiconducteurs et une structure de recâblage sur la face (31) supérieure de la bande (100) du substrat de recâblage s'effectue au moyen d'une technique de liaison.

22. Procédé suivant l'une des revendications 15 à 21, **caractérisé en ce que**
sur les groupes (5) de composants, est déposée, après la production des liaisons entre des puces (4) à semiconducteurs et la bande (100) du substrat de recâblage, des recouvrements (17) en matière plastique, qui incorporent les puces (4) à semiconducteurs dans une masse de matière plastique.

23. Procédé suivant l'une des revendications 15 à 22, **caractérisé en ce que**
les surfaces (13) de contact de contrôle et/ou les plages (10) de contact extérieur de la structure de recâblage sont revêtues sélectivement d'un alliage d'or.

24. Procédé suivant l'une des revendications 15 à 23, **caractérisé en ce que**
des billes (28) de brasage sont brasées en tant que contact (19) de contrôle sur les surfaces (13) de contact de contrôle.

25. Procédé de production de composants (3) à semiconducteurs, qui comporte les stades de procédé suivants :
- production d'une bande (100) de substrat de recâblage suivant l'une des revendications 15 à 24,
- séparation de la bande (100) de substrat de recâblage en des composants individuels et
- élimination par tri des composants (3) à semiconducteurs repérés comme étant défectueux.
